# FASCICULE DE BREVET EUROPEEN

(11) **EP 1 332 519 B1**
(45) Date de publication et mention de la délivrance du brevet: **26.07.2006**
(21) Numéro de dépôt: 01974379.8
(22) Date de dépôt: 18.09.2001
(51) Int. Cl.: H01L 27/146

(54) **MATRICE ACTIVE TFT POUR CAPTEUR OPTIQUE COMPORTANT UNE COUCHE SEMI-CONDUCTRICE PHOTOSENSIBLE, ET CAPTEUR OPTIQUE COMPORTANT UNE TELLE MATRICE**
AKTIVE TFT-MATRIX FÜR EINEN OPTISCHEN SENSOR MIT LICHTEMPFINDLICHER HALBLEITERSCHICHT, UND OPTISCHER SENSOR MIT EINER SOLCHEN MATRIX
TFT MATRIX FOR OPTICAL SENSOR COMPRISING A PHOTOSENSITIVE SEMICONDUCTOR LAYER, AND OPTICAL SENSOR COMPRISING SUCH AN ACTIVE MATRIX

(30) Priorité: 19.09.2000 FR 0011927
(43) Date de publication de la demande: 06.08.2003
(73) Titulaire: THALES AVIONICS LCD S.A., 75008 Paris (FR)
(72) Inventeur: SANSON, Eric, THALES INTELLECTUAL PROPERTY, 94117 Arceuil Cedex (FR); SZYDLO, Nicolas, F-38000 GRENOBLE (FR)
(74) Mandataire: Esselin, Sophie
(86) Numéro de dépôt international: PCT/FR2001/002900
(87) Numéro de publication internationale: WO 2002/025699

(56) Documents cités:
- EP-A- 0 814 515
- PATENT ABSTRACTS OF JAPAN vol. 2000, no. 01, 31 janvier 2000 (2000-01-31) -& JP 11 274446 A (TOSHIBA CORP), 8 octobre 1999 (1999-10-08)
- BOER DEN W ET AL: "SIMILARITIES BETWEEN TFT ARRAYS FOR DIRECT-CONVERSION X-RAY SENSORSAND HIGH-APERTURE AMLCDS" 1998 SID INTERNATIONAL SYMPOSIUM DIGEST OF TECHNICAL PAPERS. ANAHEIM, CA, MAY 17 - 22, 1998, SID INTERNATIONAL SYMPOSIUM DIGEST OF TECHNICAL PAPERS, SANTA ANA, CA: SID, US, vol. 29, 1998, pages 371-374, XP000965457 ISSN: 0098-966X
- PATENT ABSTRACTS OF JAPAN vol. 2000, no. 15, 6 avril 2001 (2001-04-06) -& JP 2000 353808 A (SHARP CORP), 19 décembre 2000 (2000-12-19)

## Description

L'invention est relative à une matrice active de TFT (thin film transistor = transistor en couche mince) pour capteur optique, du type qui comprend :
- un substrat ;
- une matrice de transistors TFT formée sur ce substrat, chaque transistor comportant une grille, une source et un drain ;
- un ensemble de lignes pour commander les transistors TFT par leurs grilles, cet ensemble de lignes étant placé sur le substrat ;
- un niveau de conducteur selon un motif déterminé formant une matrice d'électrodes, chaque électrode définissant une zone appelée pixel ;
- un ensemble de colonnes permettant un transfert de charge à travers les transistors entre les électrodes et une électronique extérieure, les colonnes étant reliées aux sources des transistors TFT ;
- une couche isolante entre les électrodes et les colonnes, cette couche isolante étant ouverte localement sur chaque pixel pour mettre en contact l'électrode de pixel et le drain du transistor TFT ;
- une couche semi-conductrice photosensible en contact avec les électrodes de pixels pour convertir le rayonnement électromagnétique en charges électriques recueillies par les électrodes,
- un ensemble de lignes de stockage formant des capacités avec les électrodes de pixels ou drains,
- et des connexions, formant des ponts, prévues pour relier électriquement les lignes de stockage successives et permettre, lors de la commande d'une ligne de pixels, de répartir l'évacuation des charges de toute la ligne de pixels sur plusieurs lignes de stockage parallèles,
   et les lignes de stockage sont prévues dans un niveau situé sur le substrat au-dessous du niveau des lignes de commande et un niveau isolant fin est situé entre le niveau des lignes de stockage et le niveau des lignes de commande.

Une matrice active de ce type peut être utilisée dans un capteur optique. Le rayonnement électromagnétique qui frappe la couche semi-conductrice photosensible est converti en charges électriques qui sont recueillies par les électrodes de pixels. Ces charges électriques sont analysées dans un circuit électronique pour restituer une image point par point, par exemple à l'aide d'afficheurs à cristaux liquides (LCD). Une utilisation particulière de matrice active de TFT concerne la réalisation d'images à partir de rayons X, la couche semi-conductrice étant avantageusement formée par du sélénium.

US 5 780 871 montre une matrice active de ce type ayant une ouverture optique de pixel élevée qui, toutefois, conduit à un couplage capacitif sensible entre électrodes de pixels et lignes, en dépit d'une couche isolante prévue pour lutter contre ce couplage ; un tel couplage capacitif va à l'encontre de la qualité d'image souhaitée.

Le document JP-A-11 274 446 décrit un capteur optique avec des pixels reliés à une ligne de transfert et avec lignes de commande et de stockage formant des capacités avec les électrodes de pixels.

Un premier but de l'invention est d'améliorer l'image restituée à partir d'un capteur optique équipé d'une matrice active de TFT telle que définie précédemment.

Pour cela, selon une première disposition de l'invention, une électrode de pixel est située entièrement à l'intérieur d'un contour délimité par deux lignes et deux colonnes successives, une distance de garde étant prévue entre le bord intérieur de ce contour et la périphérie du pixel de telle sorte que l'électrode de pixel ne recouvre ni les lignes ni les colonnes.

Dans ces conditions, le couplage capacitif entre électrode de pixel et lignes et colonnes est considérablement réduit, ce qui évite des charges parasites conduisant à une dégradation de l'image.

La diminution de l'ouverture optique qui résulte de la diminution de la surface utile du pixel n'entraîne pas de diminution sensible de récupération des charges ni de diminution de la qualité de l'image.

Ce résultat semble dû au comportement cinétique des porteurs générés dans un semi-conducteur photosensible par le rayonnement électromagnétique. En raison d'un champ latéral créé par les porteurs, ceux-ci se déplacent naturellement vers les électrodes de pixels.

Ainsi, selon l'invention, la réduction de couplage capacitif obtenue en diminuant les dimensions de l'électrode de pixel n'entraîne pas d'inconvénients en ce qui concerne la récupération des charges. La qualité de l'image restituée est améliorée.

De préférence, la distance moyenne de garde entre le contour de l'électrode de pixel et le contour extérieur formé par les lignes et les colonnes est sensiblement égale au double de la tolérance d'alignement d'un photorépéteur qui permet de réaliser les images de différents motifs et dessins de circuits et d'électrodes sur la résine de la plaque.

La valeur moyenne de la distance de garde peut être comprise entre 4 et 8 µm, de préférence de l'ordre de 6 µm.

Avantageusement, dans la matrice définie précédemment, le transistor TFT associé à chaque pixel est recouvert par l'électrode de pixel, et est ainsi protégé.

La couche isolante.prévue entre les électrodes et les colonnes, est avantageusement formée par une résine photosensible ou photo-imageable.

Selon un deuxième but de l'invention, on souhaite améliorer le contraste des images obtenues, en ayant une forte capacité sur les pixels, pour stocker des charges élevées, En effet, plus les charges stockées sont élevées, meilleur est le contraste d'image.

Toutefois, il convient que la réalisation reste simple et que le rendement de fabrication demeure élevé, notamment en évitant au maximum les défauts de courts-circuits dus à des impuretés ou à des poussières.

Selon une deuxième disposition de l'invention, qui peut être utilisée indépendamment ou en combinaison avec la disposition précédente, la matrice comprend:
- un ensemble de lignes de stockage formant des capacités avec les électrodes de pixels ou drains, ces lignes de stockage étant parallèles aux lignes de commande,
- et des connexions parallèles aux colonnes, formant des ponts, prévues pour relier électriquement les lignes de stockage successives et permettre, lors de la commande d'une ligne de pixels, de répartir l'évacuation des charges de toute la ligne de pixels sur plusieurs lignes de stockage parallèles.

De préférence, les connexions parallèles aux colonnes sont de même niveau que les colonnes.

Les lignes de stockage forment une capacité avec les électrodes de pixels ou drains, ou avec une électrode spécifique réalisée dans le même niveau que les lignes de commande , et un niveau isolant fin est situé entre le niveau des lignes de stockage et le niveau des lignes de commande .

Selon une deuxième possibilité, les lignes de stockage sont sensiblement au même niveau que les lignes de commande.

On peut prévoir un nombre de connexions parallèles aux colonnes égal au nombre de colonnes, soit un pont par pixel. Il est aussi possible de prévoir un nombre de connexions parallèles inférieur au nombre de colonnes et donc un nombre de ponts inférieur au nombre de pixels. En particulier, on peut prévoir une connexion parallèle aux colonnes toutes les seize colonnes.

Les zones de forte capacité définies par l'empilement de trois couches à savoir "niveau ligne de stockage", "isolant-fin", et "niveau conducteur supérieur" définissent des capacités planaires dans lesquelles l'isolant fin n'est jamais utilisé seul pour séparer électriquement une marche ou gradin du "niveau ligne de stockage" d'avec un "niveau conducteur supérieur". Ceci permet d'améliorer le rendement de fabrication.

De préférence, le pixel comporte un dispositif de protection contre les tensions trop élevées intégré dans le transistor lorsque l'on travaille en tension négative, ou comprenant une diode et un transistor spécifique lorsque l'on travaille en tension positive.

L'invention concerne également un capteur optique, en particulier pour rayons X, équipé d'une matrice active tette que définie précédemment.

L'invention consiste, mises à part les dispositions exposées ci-dessus, en un certain nombre d'autres dispositions dont il sera plus explicitement question ci-après à propos d'exemples de réalisation décrits avec référence aux dessins ci-annexés, mais qui ne sont nullement limitatifs.

La figure 1, de ces dessins, est une vue en plan d'un pixel d'une matrice active selon l'invention.

La figure 2 est une vue en plan, à plus petite échelle, d'un pixel et d'une connexion parallèle aux colonnes.

La figure 3 est une coupe développée suivant la ligne III-III de Fig.2.

La figure 4 est un schéma d'un pixel entouré par deux lignes de commande successives et deux colonnes successives.

La figure 5 est un schéma en plan d'une ligne de stockage comprise entre deux lignes de commande.

La figure 6 est une coupe schématique suivant la ligne VI-VI de Fig.5, à échelle différente.

La figure 7 est un schéma électrique illustrant les lignes de stockage.

La figure 8 est une coupe verticale d'une variante de réalisation de Fig.3.

La figure 9, enfin , est une coupe verticale illustrant un empilage permettant de réaliser une capacité planaire.

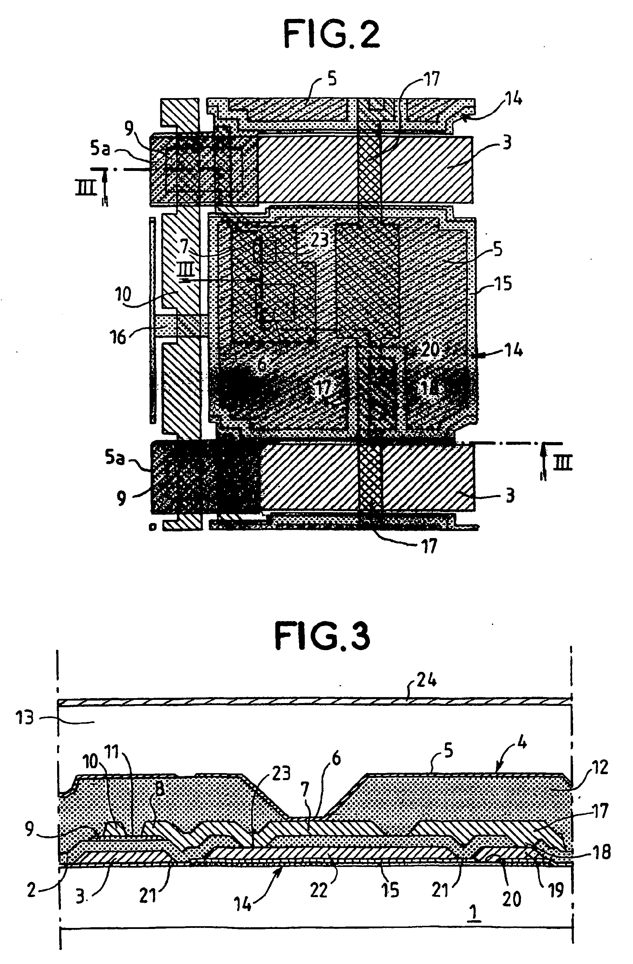

On se reporte maintenant aux dessins, notamment à Fig. 3, sur laquelle sept traits verticaux parallèles correspondent aux sept changements de direction de la ligne de coupe de Fig.2.

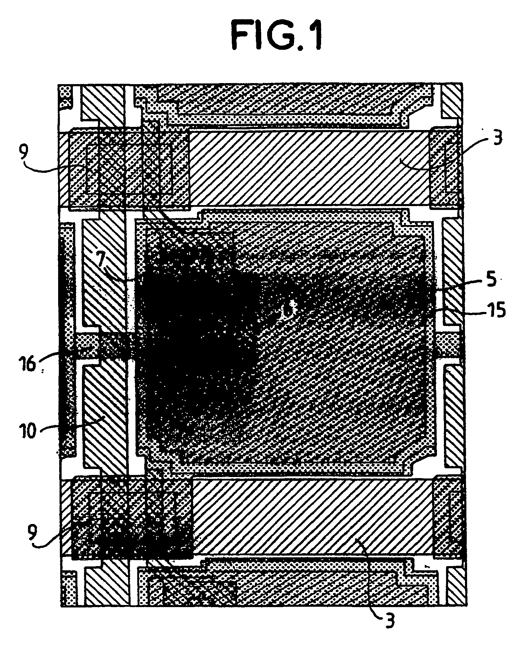

Une structure de matrice active de TFT comprend, selon Fig.3, de bas en haut, un substrat 1 généralement en verre, une couche isolante de grille 2, en nitrure de silicium ou matière équivalente, formée sur ce substrat ; un ensemble de lignes 3 de commande des transistors TFT en formant leur grille, cet ensemble 3 étant placé sur le substrat 1, sous la couche 2. Comme visible sur les Figs. 1 et 2, les lignes 3 sont parallèles et horizontales. Les lignes 3 peuvent être formées par un bi-couche titane et molybdène.

Un niveau de conducteur 4 réalisé suivant un dessin ou motif déterminé, constitue une matrice d'électrodes. Chaque électrode 5, de forme sensiblement rectangulaire ou carrée, définit une zone appelée pixel. Chaque électrode 5 est en contact, dans une zone 6 formant le fond d'une cuvette, avec une plaque conductrice 7 métallique, par exemple en molybdène, dont un bord 8 vient au-dessus et au contact d'une couche 9 de silicium amorphe, formant transistor TFT. La couche 9 recouvre une zone de la couche 2, au-dessus de la grille formée par la ligne 3. La plaque 7 forme le drain du transistor.

Une colonne 10, constituée par une bande conductrice, est également en appui contre la couche 9 à distance du bord 8. La zone 11 de la couche 9, située au-dessus de la grille 3 et comprise entre la colonne 10 et le bord 8, constitue le canal du transistor. La colonne 10 forme la source du transistor. Les différentes colonnes 10 sont parallèles entre elles , verticales selon la représentation de Fig.2 .

Une couche isolante 12 est prévue entre les électrodes 5 de pixels et les colonnes 10. La couche 12 comporte des ouvertures locales de telle sorte que chaque électrode de pixel 5 soit en contact avec la plaque 7 par sa partie référencée 6.

Une couche semi-conductrice 13 photosensible, en contact avec les électrodes 5, est prévue pour convertir les rayons X en charges électriques qui sont recueillies par les électrodes 5. La couche 13 est avantageusement réalisée en sélénium . Cette couche 13 est recouverte par une électrode supérieure 24 mise sous tension élevée.

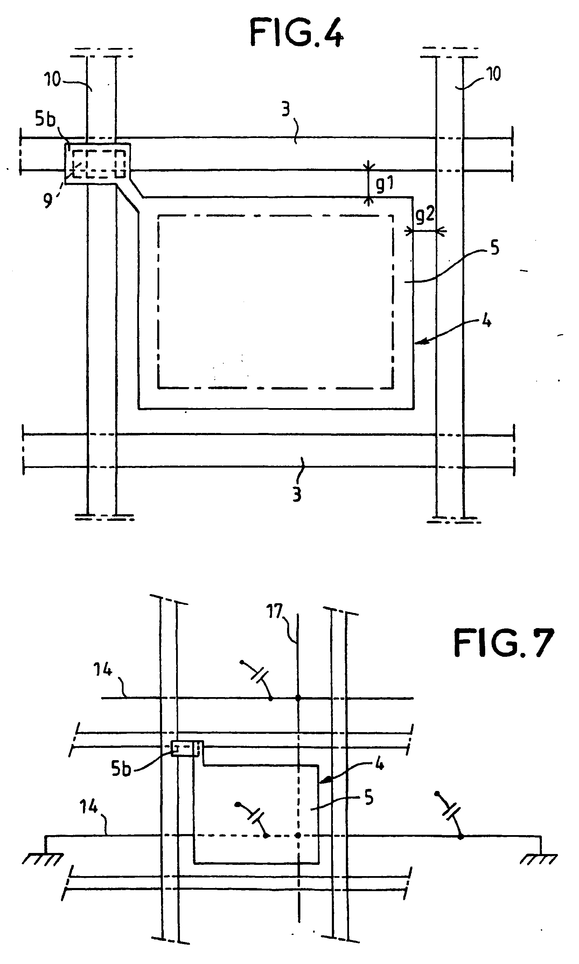

Comme illustré sur Fig.4, le contour moyen de chaque électrode de pixel 5, sensiblement rectangulaire ou carré, est situé entièrement à l'intérieur d'un contour défini par deux colonnes successives 10 et deux lignes successives 3.

Des distances de garde g1 et g2 sont prévues respectivement entre les bords de l'électrode 5 et les bords voisins des lignes 3 et des colonnes 10 . Ces distances g1, g2 sont de préférence identiques et sensiblement égales au double de la tolérance d'alignement d'un photorépéteur qui réalise, par insolation d'une résine, les différentes images correspondant aux motifs des lignes, des colonnes et des électrodes.

La valeur moyenne de g1 et g2 est avantageusement comprise entre 4 et 8 µm, de préférence sensiblement égale à 6 µm pour des pixels 5 répartis suivant un pas de l'ordre de 150 µm (le pas correspond à la distance entre les centres des pixels 5).

Avec une telle configuration, l'électrode 5 du pixel ne recouvre ni les lignes 3 ni les colonnes 10 de sorte que les capacités parasites entre l'électrode 5 de pixel et les lignes et colonnes sont sensiblement réduites.

Bien que la surface de l'électrode de pixel 5 soit diminuée, les charges électriques sont récupérées par cette électrode quasiment aussi bien que si son ouverture optique était nettement supérieure et voisine de 100 %, en raison du champ latéral créé par les porteurs comme expliqué précédemment.

Il en résulte une bonne qualité de l'image obtenue à partir des charges électriques récupérées par les pixels.

Pour stocker un maximum de charges électriques sur le pixel en vue d'obtenir un contraste d'image aussi bon que possible, on s'efforce de créer une forte capacité sur le pixel 5.

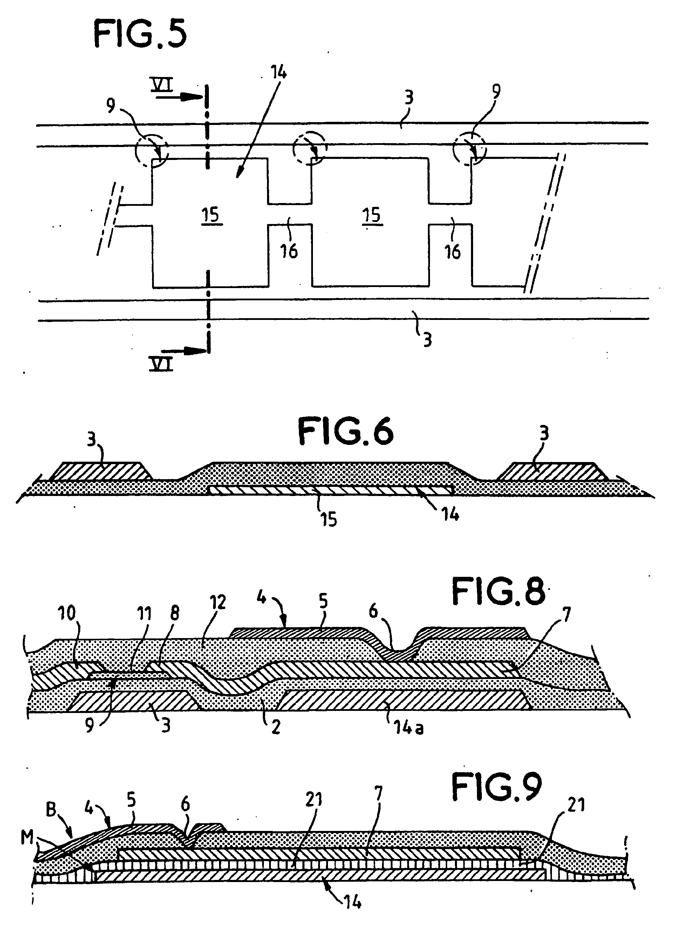

Pour cela, on prévoit des lignes de stockage 14 (Figs.2, 3 et 5) constituées par une surface conductrice, métallique, par exemple en titane, formant un bus de masse. Une ligne 14, comme illustré sur Fig. 5, est constituée par une succession de surfaces rectangulaires 15 situées à un niveau différent mais en vis-à-vis d'une électrode de pixel, de manière à former les deux plaques d'une capacité. Les surfaces 15 sont reliées par des bandes plus étroites 16 situées à mi-largeur.

Comme bien montré par la coupe de Fig.3. de préférence le bus de masse ou ligne de stockage 14 n'est pas dans le même plan que les lignes de commande 3 et n'est pas superposé, même en partie, à ces lignes. Les défauts de courts-circuits qui pourraient être créés par des poussières ou des impuretés se trouvent considérablement réduits par rapport au cas où il y aurait une superposition, ou une juxtaposition .

L'évacuation des charges par les lignes de stockage 14 (15,16) est commandée par les transistors 9, schématiquement représentés par des cercles sur Fig.5, en réponse à un signal fourni sur une ligne de commande 3 appropriée.

La disposition des lignes de stockage 14 parallèles aux lignes de commande 3 et écartées de celles-ci, tout en présentant l'avantage de réduire les risques de courts-circuits qui seraient nettement augmentés si les lignes de stockage étaient perpendiculaires aux lignes 3 et venaient à les croiser plusieurs fois, crée cependant le problème suivant.

La commande de lecture des pixels s'effectuant ligne par ligne horizontale, lorsqu'un signal de lecture est envoyé sur une ligne 3, la totalité des charges accumulées par les pixels de la ligne associée doit être évacuée par le bus de masse 14 formé par les surfaces 15 et les bandes 16 associées à la ligne de pixels correspondante (voir Fig.5).

Or, la résistance électrique du bus de masse 14 est trop élevée pour permettre un écoulement satisfaisant des charges accumulées.

Pour surmonter cette difficulté, on prévoit des connexions 17 parallèles aux colonnes 10 et sensiblement de même niveau; les connexions 17, schématiquement représentées sur Fig.7, relient électriquement les lignes de stockage 14 successives. Comme visible d'après les Figs. 2 et 3, un contact électrique est établi entre une connexion 17 et une ligne de stockage 14 par une saillie 18 en forme de tronc de pyramide renversé en appui contre une plaque conductrice 19. Cette plaque 19 est elle-même posée sur une saillie 20, en forme de tronc de pyramide renversé, réalisée dans une couche 21 d'isolant fin pour venir au contact d'une surface 15 d'une ligne de stockage 14.

Dans ces conditions, les charges d'une ligne de pixels 5 pourront être évacuées par plusieurs lignes de stockage 14 en parallèle, comme bien visible sur Fig.7 où les capacités formées entre les lignes 14 et les électrodes 5 de pixels sont schématiquement représentées. Les lignes 14 sont reliées à une tension de référence.

On peut prévoir une connexion ou pont 17 par élément d'image ou pixel mais le nombre de connexions 17 peut être inférieur au nombre d'éléments d'image ou pixel.

On peut ainsi prévoir un pont 17 pour N colonnes. En particulier, on prévoit un pont 17 toutes les seize colonnes 10.

Selon une première possibilité, illustrée sur Fig.3, les lignes de stockage 14 sont situées sur le substrat 1, au-dessous du niveau des lignes de commande 3. Une électrode spécifique 22, par exemple dans le même métal que celui des lignes 3 est prévue au même niveau que les lignes de commande 3 dont elle est isolée. L'électrode 22 est située sous la majeure partie de l'électrode de pixel 5, et est isolée de la plaque 19 et des ponts 17. Un contact électrique est établi entre le fond 23 d'une cuvette prévue dans la plaque 7 ou drain, et l'électrode 22. La couche d'isolant fin 21 sépare l'électrode 22 de la ligne de stockage 14.

Une capacité de stockage est ainsi formée entre l'électrode spécifique 22, reliée electriquement à l'électrode de pixel 5, et la zone en regard de la ligne 14.

Bien entendu, il est possible de réaliser la capacité de stockage directement entre l'électrode de pixel 5, ou le drain 7, et la ligne 14, sans faire appel à l'électrode spécifique 22.

Selon une deuxième possibilité, illustrée sur Fig.8, les lignes de stockage 14a sont au même niveau que les lignes de commande 3 , et leur sont parallèles. La capacité de stockage est alors formée directement entre l'électrode de pixel 5, ou le drain 7, et la ligne 14a.

Les zones de forte capacité (Fig. 9) définies par l'empilement de trois couches à savoir une couche conductrice 14 constituant un "niveau situé sur le substrat", une couche 21 d"'isolant fin", et un niveau conducteur supérieur B, définissent des capacités planaires c'est-à-dire que l'isolant fin 21 n'est jamais utilisé seul pour séparer électriquement une marche ou un gradin tel que M et un niveau conducteur supérieur. Ceci permet d'améliorer le rendement de fabrication et d'éviter les risques de courts-circuits créés par des poussières ou des impuretés.

Le pixel 5 peut en outre posséder un dispositif de protection contre les tensions trop élevées. Ce dispositif de protection est intégré dans le transistor 9 lorsque l'on travaille sous une tension négative appliquée à l'électrode supérieure 24 au-dessus de la couche de sélénium.

Comme visible sur les Figs. 1, 2, 4 et 7, le transistor TFT 9 de chaque pixel est recouvert par l'électrode d'un pixel : chaque électrode 5 comporte, à son angle inférieur gauche selon Figs. 1 et 2 ou à son angle supérieur gauche selon Figs. 4 et 7, une sorte de patte rectangulaire 5a, 5b, en saillie latérale et transversale qui recouvre le transistor. Il en résulte une protection du transistor contre des surtensions.

Si une tension positive est appliquée à cette électrode 24, le dispositif de protection peut comprendre une diode ou un transistor spécifique limitant à une valeur déterminée la tension appliquée au pixel.

Un capteur optique équipé d'une matrice active selon l'invention est particulièrement performant en raison de l'optimisation du pixel élémentaire 5 en ce qui concerne son dessin et sa fabrication.

## Revendications

1. Matrice active TFT pour capteur optique comprenant:
- un substrat (1) ;
- une matrice de transistors TFT (9) formée sur ce substrat, chaque transistor (9) comportant une grille, une source et un drain ;
- un ensemble de lignes (3) pour commander les transistors TFT (9) par leurs grilles, cet ensemble de lignes étant placé sur le substrat ;
- un niveau de conducteur (4) selon un motif déterminé formant une matrice d'électrodes (5), chaque électrode (5) définissant une zone appelée pixel ;
- un ensemble de colonnes (10) permettant un transfert de charge à travers les transistors entre les électrodes (5) et une électronique extérieure, les colonnes étant reliées aux sources des transistors TFT ;
- une couche isolante (12) entre les électrodes (5) et les colonnes (10), cette couche isolante étant ouverte localement sur chaque pixel pour mettre en contact (6) l'électrode de pixel et le drain (7) du transistor (9) ;
- une couche semi-conductrice photosensible (13) en contact avec les électrodes de pixels pour convertir le rayonnement électromagnétique en charges électriques recueillies par les électrodes,
- un ensemble de lignes de stockage (14) formant des capacités avec les électrodes de pixels (5) ou drains (7),
- et des connexions (17), formant des ponts, prévues pour relier électriquement les lignes de stockage successives (14) et permettre, lors de la commande d'une ligne de pixels, de répartir l'évacuation des charges de toute la ligne de pixels sur plusieurs lignes de stockage parallèles (14, 14a),
**caractérisé en ce que**
les lignes de stockage (14) sont prévues dans un niveau situé sur le substrat au-dessous du niveau des lignes de commande (3) et un niveau isolant fin (21) est situé entre le niveau des lignes de stockage (14) et le niveau des lignes de commande (3).

2. Matrice selon la revendication 1, **caractérisée en ce que** les lignes de stockage (14) sont parallèles aux lignes de commande (3), les connexions étant parallèles aux colonnes.

3. Matrice selon l'une quelconque des revendications 1 et 2,
**caractérisée en ce que** les lignes de stockage (14) forment une capacité avec une électrode spécifique (22) réalisée dans le même niveau que les lignes de commande et reliée électriquement à l'électrode de pixel (5).

4. Matrice selon la revendication 1, **caractérisée par le fait que** les connexions parallèles (17) sont de même niveau que les colonnes (10):

5. Matrice selon l'une des revendications 1 à 4, **caractérisée par le fait que** le nombre de connexions (17) parallèles aux colonnes (10) est égal au nombre de colonnes.

6. Matrice selon l'une des revendications 1 à 4, **caractérisée par le fait que** le nombre de connexions (17) parallèles aux colonnes (10) est inférieur au nombre de colonnes.

7. Matrice selon la revendication 6, **caractérisée par le fait qu'**elle comporte une connexion (17) parallèle aux colonnes (10) toutes les seize colonnes (10).

8. Matrice selon l'une des revendications précédentes **caractérisée par le fait que** les zones de forte capacité définies par l'empilement de trois couches à savoir "niveau situé sur le substrat" (14), "isolant fin" (21), et "niveau conducteur supérieur" (B) définissent des capacités planaires dans lesquelles l'isolant fin (21) n'est jamais utilisé seul pour séparer électriquement une marche (M) du "niveau ligne de stockage" (14) d'avec un "niveau conducteur supérieur" (B).

9. Matrice selon l'une des revendications précédentes **caractérisée par le fait que** le pixel comporte un dispositif de protection contre les tensions trop élevées.

10. Capteur optique, en particulier pour rayons X, comportant une matrice selon l'une des revendications 1 à 9.

## Claims

1. TFT active matrix for an optical sensor comprising:
- a substrate (1);
- a matrix of TFT transistors (9) formed on this substrate, each transistor (9) comprising a gate, a source and a drain;
- a set of row lines (3) for controlling the TFT transistors (9) by means of their gates, this set of row lines being placed on the substrate;
- a conducting level (4) in a particular pattern forming a matrix of electrodes (5), each electrode (5) defining a zone called a pixel;
- a set of column lines (10) making it possible to transfer charge through the transistors between the electrodes (5) and external electronics, the column lines being connected to the sources of the TFT transistors;
- an insulating layer (12) between the electrodes (5) and the column lines (10), this insulating layer being open locally over each pixel in order to put the pixel electrode in contact (6) with the drain (7) of the transistor (9);
- a photosensitive semiconducting layer (13) in contact with the pixel electrodes in order to convert the electromagnetic radiation into electric charges collected by the electrodes,
- a set of storage row lines (14) forming capacitors with the pixel electrodes (5) or drains (7),
- and connections (17), forming bridges, provided in order to electrically connect the successive storage row lines (14) and to make it possible, when controlling a row of pixels, to distribute the removal of charges from the entire row of pixels over several parallel storage row lines (14, 14a),
**characterized in that**
the storage row lines (14) are provided in a level located on the substrate below the level of the control row lines (3) and a thin insulating level (21) is located between the level of the storage row lines (14) and the level of the control row lines (3).

2. Matrix according to Claim 1, **characterized in that** the storage row lines (14) are parallel to the control row lines (3), the connections being parallel to the column lines.

3. Matrix according to either of Claims 1 and 2, **characterized in that** the storage row lines (14) form a capacitor with a specific electrode (22) made in the same level as the control row lines and electrically connected to the pixel electrode (5).

4. Matrix according to Claim 1, **characterized in that** the parallel connections (17) are at the same level as the column lines (10).

5. Matrix according to one of Claims 1 to 4, **characterized in that** the number of connections (17) parallel to the column lines (10) is equal to the number of column lines.

6. Matrix according to one of Claims 1 to 4, **characterized in that** the number of connections (17) parallel to the column lines (10) is less than the number of column lines.

7. Matrix according to Claim 6, **characterized in that** it comprises a connection (17) parallel to the column lines (10) every sixteen column lines (10).

8. Matrix according to one of the preceding claims, **characterized in that** the high-capacitance zones defined by the stack of three layers, that is "level placed on the substrate" (14), "thin insulator" (21), and "upper conducting level" (B), define planar capacitors in which the thin insulator (21) is never used alone in order to electrically separate a step (M) of the "storage row line level" (14) from an "upper conducting level" (B).

9. Matrix according to one of the preceding claims, **characterized in that** the pixel comprises a device for protecting against voltages which are too high.

10. Optical sensor, in particular for X-rays, comprising a matrix according to one of Claims 1 to 9.

## Patentansprüche

1. Aktive TFT-Matrix für einen optischen Sensor, die aufweist:
- ein Substrat (1) ;
- eine Matrix von TFT-Transistoren (9), die auf diesem Substrat ausgebildet ist, wobei jeder Transistor (9) ein Gate, eine Source und einen Drain aufweist;
- eine Einheit von Zeilen (3), um die TFT-Transistoren (9) über ihre Gates zu steuern, wobei diese Einheit von Zeilen auf dem Substrat angeordnet ist;
- eine Leiterebene (4) gemäß einem bestimmten Muster, die eine Matrix von Elektroden (5) bildet, wobei jede Elektrode (5) eine Pixel genannte Zone definiert;
- eine Einheit von Spalten (10), die eine Ladungsübertragung durch die Transistoren hindurch zwischen den Elektroden (5) und einer externen Elektronik ermöglicht, wobei die Spalten mit den Sourcen der TFT-Transistoren verbunden sind;
- eine isolierende Schicht (12) zwischen den Elektroden (5) und den Spalten (10), wobei diese isolierende Schicht lokal an jedem Pixel offen ist, um die Pixelelektrode und den Drain (7) des Transistors (9) in Kontakt zu bringen (6);
- eine fotoempfindliche halbleitende Schicht (13) in Kontakt mit den Pixelelektroden, um die elektromagnetische Strahlung in elektrische Ladungen umzuwandeln, die von den Elektroden aufgefangen werden,
- eine Einheit von Speicherzeilen (14), die Kondensatoren mit den Pixelelektroden (5) oder Drains (7) bilden,
- und Brücken bildende Verbindungen (17), die vorgesehen sind, um die aufeinanderfolgenden Speicherzeilen (14) elektrisch zu verbinden und bei der Steuerung einer Pixelzeile die Verteilung der Ableitung der Ladungen der ganzen Zeile von Pixeln über mehrere parallele Speicherzeilen (14, 14a) zu ermöglichen,
**dadurch gekennzeichnet, dass** die Speicherzeilen (14) in einer Ebene vorgesehen sind, die sich auf dem Substrat unterhalb der Ebene der Steuerzeilen (3) befindet, und eine dünne Isolierebene (21) sich zwischen der Ebene der Speicherzeilen (14) und der Ebene der Steuerzeilen (3) befindet.

2. Matrix nach Anspruch 1, **dadurch gekennzeichnet, dass** die Speicherzeilen (14) parallel zu den Steuerzeilen (3) sind, während die Verbindungen parallel zu den Spalten sind.

3. Matrix nach einem der Ansprüche 1 und 2, **dadurch gekennzeichnet, dass** die Speicherzeilen (14) einen Kondensator mit einer spezifischen Elektrode (22) bilden, die auf der gleichen Ebene ausgebildet ist wie die Steuerzeilen und elektrisch mit der Pixelelektrode (5) verbunden ist.

4. Matrix nach Anspruch 1, **dadurch gekennzeichnet, dass** die parallelen Verbindungen (17) auf der gleichen Ebene liegen wie die Spalten (10).

5. Matrix nach einem der Ansprüche 1 bis 4, **dadurch gekennzeichnet, dass** die Anzahl von Verbindungen (17) parallel zu den Spalten (10) gleich der Anzahl von Spalten ist.

6. Matrix nach einem der Ansprüche 1 bis 4, **dadurch gekennzeichnet, dass** die Anzahl von Verbindungen (17) parallel zu den Spalten (10) geringer ist als die Anzahl von Spalten.

7. Matrix nach Anspruch 6, **dadurch gekennzeichnet, dass** sie alle sechzehn Spalten (10) eine Verbindung (17) parallel zu den Spalten (10) aufweist.

8. Matrix nach einem der vorhergehenden Ansprüche, **dadurch gekennzeichnet, dass** Zonen hoher Kapazität, die von der Stapelung von drei Schichten gebildet werden, nämlich der "auf dem Substrat befindlichen Ebene" (14), "der dünnen Isolierung" (21), und der "oberen leitenden Ebene" (B), planare Kondensatoren bilden, bei denen die dünne Isolierung (21) niemals alleine genutzt wird, um elektrisch eine Stufe (M) der "Speicherzeilenebene" (14) von einer "oberen Leiterebene " (B) zu trennen.

9. Matrix nach einem der vorhergehenden Ansprüche, **dadurch gekennzeichnet, dass** das Pixel eine Schutzvorrichtung gegen zu hohen Spannungen aufweist.

10. Optischer Sensor, insbesondere für Röntgenstrahlen, der eine Matrix nach einem der Ansprüche 1 bis 9 aufweist.
